# EUROPEAN PATENT APPLICATION

(11) **EP 4 635 368 A1**
(43) Date of publication of application: **22.10.2025**
(21) Application number: 25171136.2
(22) Date of filing: 17.04.2025
(51) Int. Cl.: A47B 96/20, H10K 77/10

(54) **PANEL FOR PARTS OF FURNITURE AND FURNISHINGS IN GENERAL, WITH TRANSFORMABLE FACE THAT CAN BE COORDINATED WITH THE FURNITURE**

(30) Priority: 18.04.2024 IT 202400008881
(71) Applicant: Seven Oaks Properties Development Ltd, 3032 Limassol (CY)
(72) Inventor: BERGAMO, Anna, Verbier (CH)
(74) Representative: Metroconsult Srl

(57) **Abstract**

The invention relates to a panel for making furniture or parts thereof, such as doors, walls, drawers, shelves, and the likes, wherein at least one face (11) of the central nucleus or core (10) is coated with a sheet (12) of a pixel matrix adapted for image reproduction.

The matrix uses TFT (Thin-Film-Transistor) or OLED (Organic Light Emitting Diode) technology, or any other technology that allows changing the exterior appearance of the panel with any colour or graphic pattern.

## Description

Under a general aspect, the present invention relates to panels used for making furniture or parts thereof, such as doors, walls, drawers, shelves, and the like.

As is known, wardrobes, shelves, cupboards and furnishings in general are available in a wide variety of different combinations as regards materials, colours and surface finishing.

The ever-increasing number of requests for customization coming from customers and interior/furnishing designers, have led furniture manufacturers to do their best to meet the market demand.

This has compelled furniture manufacturers and their suppliers to diversify and broaden their product selections.

For example, there are pieces of furniture and parts thereof consisting of plywood, honeycombed or chipboard panels, or having a metal structure (e.g. aluminium, steel, etc.) or a plastic structure (PVC, fibreglass, carbon fibre, etc.), as well as furnishings using recycled materials in compliance with today's established trend towards reducing the impact on the environment and increasing the sustainability of industrial productions.

All such pieces of furniture and parts thereof have panels with an outer face provided with a surface finishing that has to be changed to meet many different requests, as mentioned above. Therefore, there are panels with outer faces consisting of painted or treated wood layers, panels covered with glass or plastic sheets, as well as laminated panels made up of sheets of synthetic materials such as methacrylates (e.g. PMMA), polycarbonates or other polymers (e.g. resins, fibreglass, carbon fibre, etc.).

Considering also all the various painting, glazing, enamelling, polishing, varnishing, etc. treatments, it can be easily understood that virtually unlimited combinations are possible.

Manufacturers usually offer a limited number of solutions, depending also on their size and production capabilities.

However, product ranges cannot be broadened too much because this would require industrial furniture manufacturers to employ an extremely large number of resources and personnel, resulting in higher investments and production costs which, for obvious economical and organizational reasons, should preferably be kept low or anyway limited.

The final user's viewpoint should also be taken into account, in that, for customers wanting to purchase furniture, it may be difficult to choose among all such alternative solutions because they do not have sufficient technical knowledge. After having made their choice, although assisted by professionals, architects or furniture experts, they may want to change, but it may be too late.

In brief, it can be stated that, in the field of furniture and furnishings in general, there is a need to reconcile the market demand for product differentiation with an adequate industrial offer that can be produced industrially in an economically sustainable way and in line with the current environmental trends.

The technical problem underlying the present invention is therefore that of fulfilling this need. The idea for solving this problem is to provide a panel for making furniture, furnishings or parts thereof, whose exterior appearance can be changed at will without the internal structure having to be modified, so that it can be adapted to specific requirements.

It follows that, in order to manufacture furniture, furnishings, or parts thereof, it will no longer be necessary to have an extreme diversification of machinery and materials for industrial production, thereby overcoming the above-mentioned problems currently suffered by the industry.

Furthermore, in accordance with a preferred embodiment of the invention, the exterior appearance of the panel can be varied and updated at any time to change the effect of the piece of furniture on the surrounding environment.

For example, one may want to use different configurations for day and night, or anyway depending on the illumination conditions of an environment.

In accordance with a preferred possible embodiment of the invention, the panel has an outer face coated, or covered, with a pixel matrix suitable to display colour images.

Preferably, said matrix uses TFT (Thin-Film-Transistor) or OLED (Organic Light Emitting Diode) technology, or a combination thereof, or combined with other suitable technologies. In particular, according to the invention, the image matrix covers the whole face of the panel of the invention, so that the latter can be arranged alongside similar panels of the same piece of furniture or furnishing, displaying the image without solution of continuity.

The features of the panel of the invention are specifically set out in the claims appended to this description.

Such features, as well as the effects thereof and the advantages of the invention, will become more apparent in light of an illustrative implementation of the invention that will be described below with reference to the accompanying drawings, provided by way of non-limiting example, wherein:
Figs. 1 to 4 show respective views of an environment with furnishings according to the invention, in different exterior configurations;
Figs. 5 and 6 show respective separate details of panels according to the invention;
Figs. 7 (a), (b), (c) show another example of a piece of furniture according to the invention, in respective exterior configurations.

With reference to the above-listed figures, numeral 1 designates as a whole a panel for making parts of furniture in accordance with the invention.

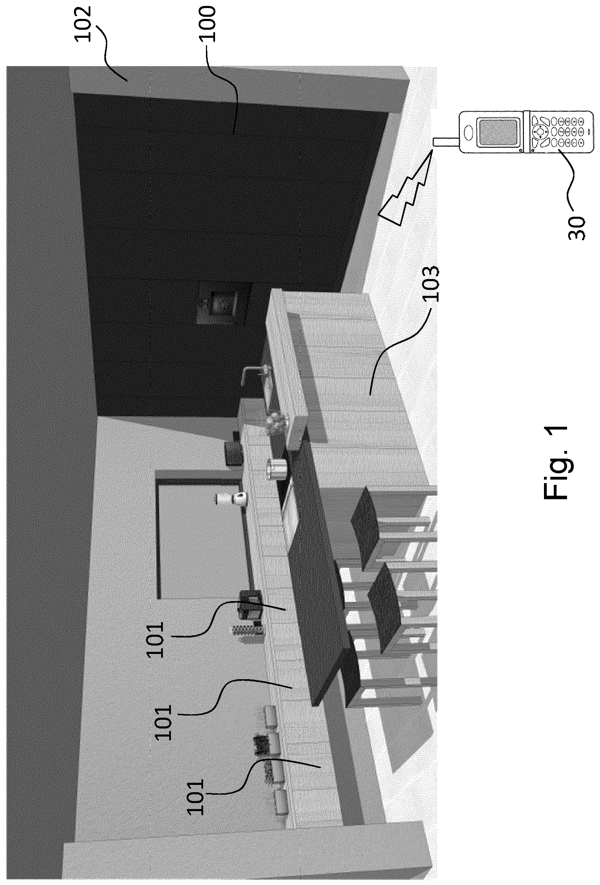

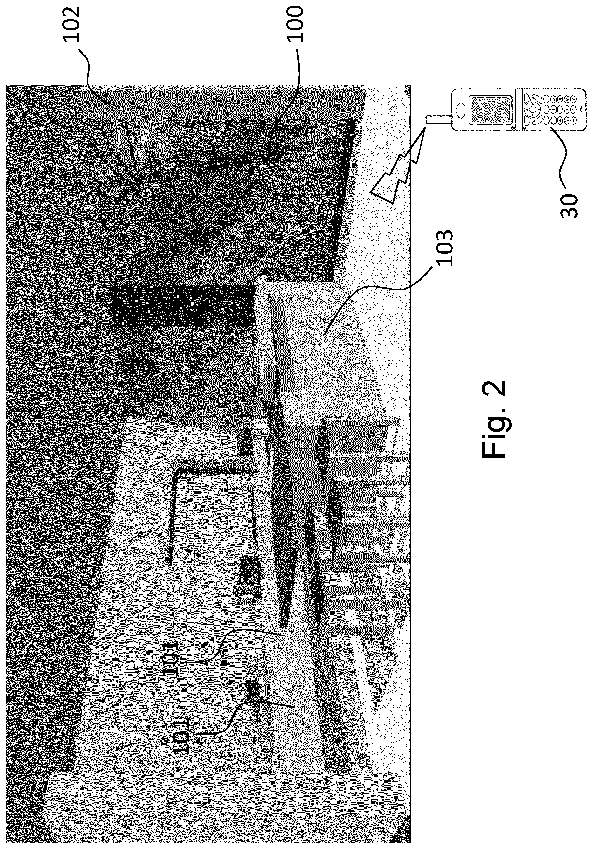

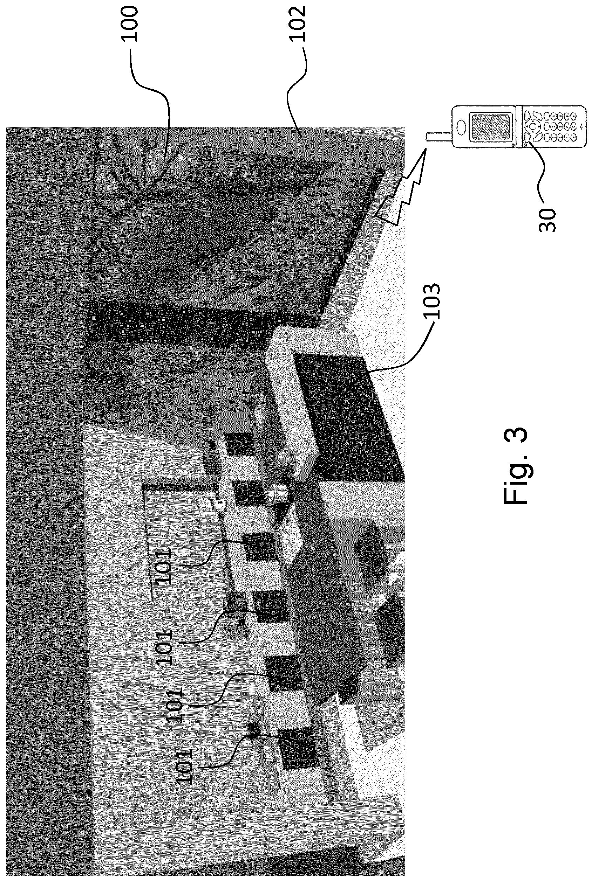

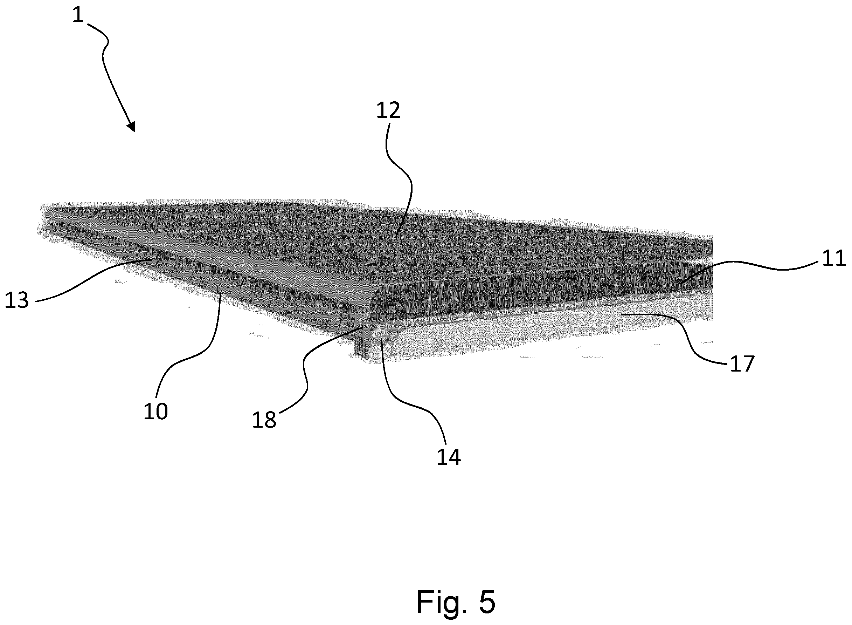

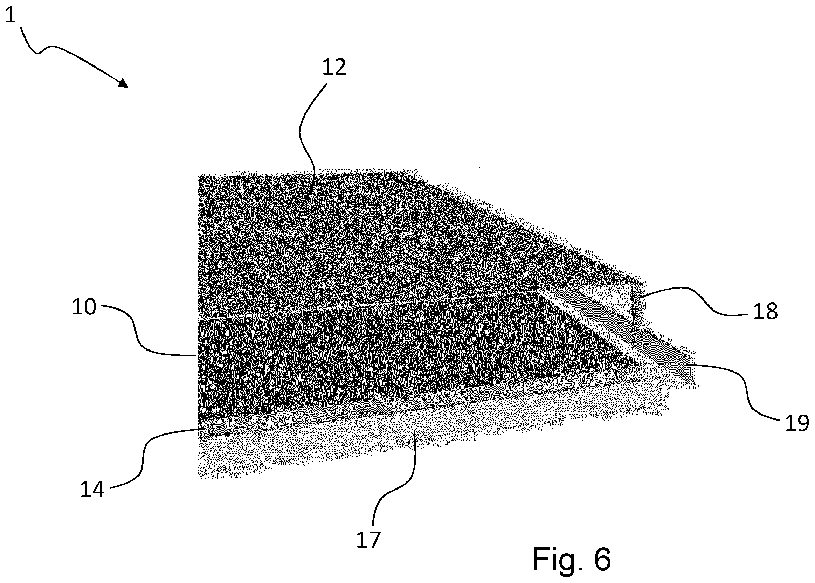

The panel shown in Figures 5 and 6, as well as those of the furnishings shown in Figures 1 to 4, are essentially flat and rectangular.

This should not be considered as a limitation, since the panel of the invention may also have different shapes, e.g. concave or convex or non-rectangular shapes; for example, the panels may be square, circular or polygonal, or may have complex profiles.

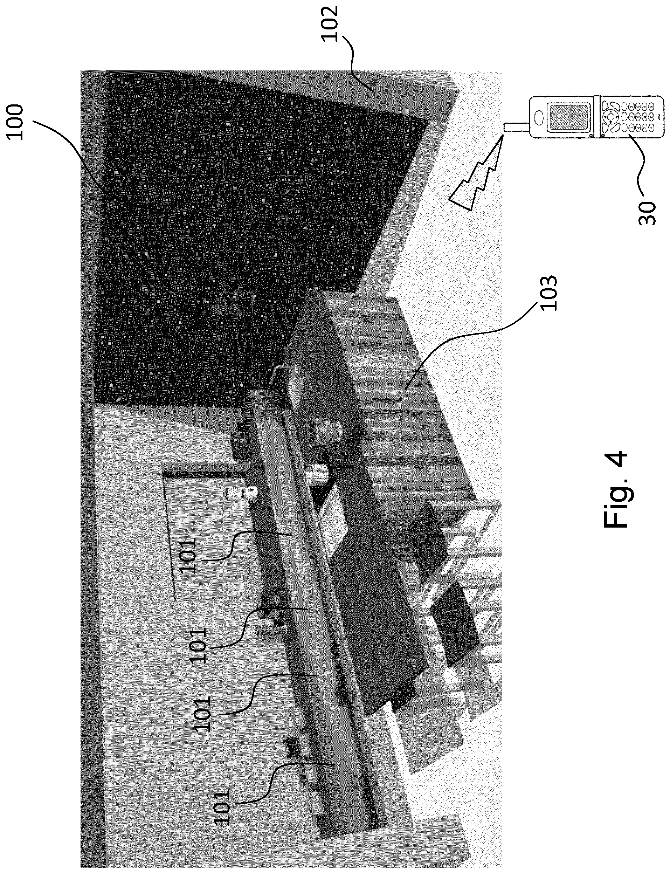

The panel 1 has a central core or nucleus 10 that, in the example of Figs. 4 and 5, consists of a chipboard or plywood sheet, or the like.

In this case as well, the central core 10 may consist of a sheet other than a chipboard sheet, e.g. it may have a metal, wooden, plastic, etc. structure configured as a frame or provided with infill faces, etc.

On a face 11 of the core 10 there is applied a sheet 12 with an OLED (AMOLED type) matrix, which is suitable for image reproduction, preferably at high resolution (HD), i.e. having a size of at least 1,280 pixels in width and 720 pixels in height.

These values are average values for a panel having a size of approximately 60 cm in width and 40 cm in height; therefore, sheets 12 with a higher or lower number of pixels may be provided. The sheet 12 is fixed to the core 10 of the panel by adhesive or another suitable system, so as to coat the whole face 11 and also, preferably, the longitudinal edge 13, i.e. the major side, so that the image extends beyond the face 11.

In this manner, an effect of image continuity can be obtained on that part of the piece of furniture where the panel 1 is used, e.g. doors 100 and 101 of wardrobes and cupboards, or wardrobe walls 102, 103, in the furnishings of Figures 1-4, which will be further discussed below.

In the example considered herein, the sheet 12 does not extend along the minor side 14 of the panel, although panels may be provided wherein the minor side is also coated, whether wholly or partly, with a portion of the sheet 12.

Flexible OLED sheets that can be used for the invention are commercially available, such as, for example, those industrially produced by renowned companies like Samsung, LG, BOE Technology Group, etc.

In the preferred embodiment of the panel 1, the OLED sheet 12 comprises a system for managing the operation of the pixel matrix through software installed on an electronic component 17, preferably of the processor-based type, and an interface 18 for receiving and managing images coming from external media, which can operate via Wi-Fi, USB, connections to PCs, WebOS TVs, Miracast protocols, etc.

Advantageously, the first one of such elements can be applied to the minor side of the core 10 of the panel, so as to act also as a finishing element to keep the panel appearance unchanged. The panel 1 made accordingly can be used for the production of pieces of home furniture as schematically shown in Figures 1-4, of course in different sizes to match the furniture parts involved.

It is thus possible to produce panels 101 for cupboard doors, other bigger panels 100 for wardrobe doors, or panels 102, 103 for furniture walls in general.

The possible applications of the panels according to the invention are not, however, limited to those shown in Figures 1-4, since they also extend to other furnishings or parts thereof not explicitly illustrated herein, such as, for example, drawers, shelves, and the like.

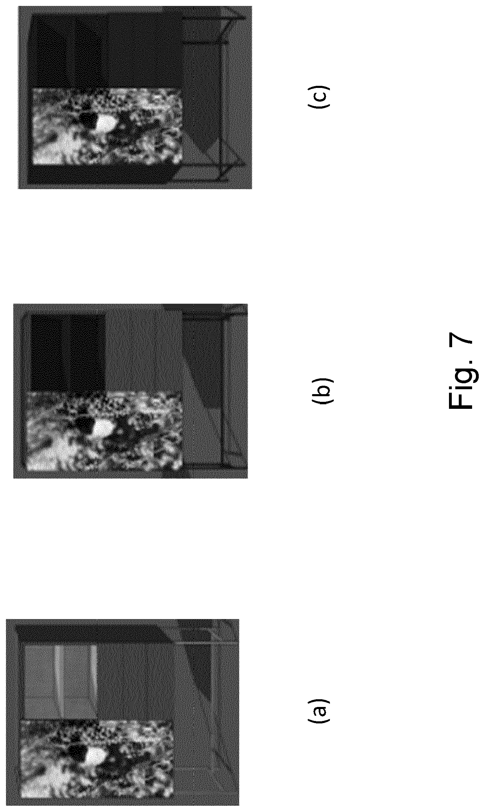

For sake of convenience reference should be made to Figure 7, where the parts designated as (a), (b), (c) illustrate a piece of furniture with drawers, a door and a shelf with respective differentiated exteriors.

The panel 1 according to the invention operates on electricity, preferably supplied by a rechargeable battery 19 of the lithium-polymer type, or the like, which can advantageously be configured to be embedded, or anyway be integrated, in the panel 1.

For example, the battery may be configured as a thin strip applicable along one of the edges of the core 10 of the panel; as an alternative, the latter may include a cavity or slot adapted to house the battery 19.

The latter supplies power to the management system 17 and to the interface 18, as well as to the OLED pixel matrix of the sheet 12, so that the exterior appearance of the panel 1 can be configured through commands issued externally by means of a control system, which is preferably a wireless one.

To this end, several solutions are possible depending on different choices.

For example, the exterior configuration of the panels 1 may be managed from a portable device 30, such as a cellular phone, an electronic computer like a PC, a tablet, or the like, which sends commands to the panels via electromagnetic waves (e.g. over a Wi-Fi, Bluetooth, etc. connection).

Thus, systems can be created wherein the panels 1, 100-103 of a piece of furniture are mutually independent, and the mobile device 30 sends commands to each one of them through respective interfaces 18 operating as antennae, or other solutions are also possible wherein the panels 1, 100-103 are mutually connected (e.g. in a grid, in a mesh, in series, in parallel, etc.) and the device 30 sends commands to only one or some of them.

Furthermore, the connection of the panels 1-103 may also be a wireless one (e.g. a IOT telecommunications connection), thus clearing the way for multiple possible combinations for managing furniture panels in a furnished house or environment.

From the above description it can be understood that the composite panel of the invention provides a solution to the technical problem outlined at the beginning the present specification. As a matter of fact, by coating one face 11 of the panel with the OLED matrix sheet 12, it is possible to have the panel 1 assume any exterior appearance as required, both in terms of colours and in terms of graphic patterns.

It follows that, from an industrial production viewpoint, furnishings and parts thereof can be customized with any exterior finishing through panels all equal to one another that can be customized by choosing a colour and/or an image to be reproduced on the OLED pixel matrix of the sheet 12.

This can be easily done by means of the mobile device 30 without requiring any additional equipment or processing, which would otherwise be necessary for industrial production according to the prior art.

In this context, it should also be pointed out that furniture customization can also be changed by the final user, which makes the invention even more advantageous.

Furthermore, it should be observed that the use of an image reproduction system employing OLED technology makes it possible to use the pixel matrix sheet 12 as an environmental light and also as an internal wardrobe illumination element.

In other words, in the panels according to the invention the OLED matrix sheet 12 can be applied also to the inward face of wardrobes, cupboards and other pieces of furniture to create an internal illumination source that makes the objects more visible when they have to be removed.

Lastly, it should be highlighted that, as an alternative to OLED technology, for the pixel matrix of the sheet 12 one may also use TFT (Thin Film Transistor) technology.

Based on the above description, the illustrated concepts can also be extended to applications not directly related to furniture, but concerning different furnishing solutions such as apartment walls or commercial premises, which will thus be able to assume a different exterior appearance as required, both in terms of colours and in terms of graphic patterns. By way of example, panels like those designated as 100 and 102 can also be used for bigger applications, in particular on walls of apartments or commercial premises. For such applications as well, the functionality of the invention is exactly the same as described above for furniture applications, permitting the creation of any desired graphic solution and, most importantly, allowing for graphic communication changes.

## Claims

1. Panel for making furniture, furnishings or parts thereof, such as doors, walls, drawers, shelves, and the like, wherein a nucleus or core (10) comprises at least one face (11) coated with an external finishing layer or sheet (12), **characterized in that** the sheet comprises a pixel matrix adapted for image reproduction.

2. Panel according to claim 1, wherein the matrix is of the TFT (Thin-Film-Transistor) or OLED (Organic Light Emitting Diode) type, or a combination thereof, or combined with other suitable technologies.

3. Panel according to claim 1 or 2, wherein the sheet (12) extends along at least one edge (13) of the face (11) of the core (10), so as to permit the reproduction of images substantially without solution of continuity with panels adjacent thereto along such edge (13).

4. Panel according to any one of the preceding claims, comprising a system for managing the operation of the pixel matrix through a (software) program installed on an electronic component (17), preferably of the processor-based type, and an interface (18) for receiving and managing images coming from external media (30).

5. Panel according to any one of the preceding claims, comprising a rechargeable battery (19) supplying power to the sheet (12) of the pixel matrix, so configured as to be embedded, or anyway integrated, in the core (10) of the panel.

6. Panel according to claim 5, wherein the battery (19) is configured essentially as a thin strip applicable along one of the edges of the core (10) of the panel.

7. Panel according to claims 5 or 6, wherein the core (10) includes a cavity or slot adapted to house the battery (19).

8. Panel according to any one of the preceding claims, comprising an electronic component (17), preferably of the processor-based type, and/or an interface (18) for receiving and managing images coming from external media (30), which are applied along the edges of the core (10) of the panel.

9. Piece of furniture comprising at least one panel (1) according to the preceding claims.

10. Piece of furniture comprising a plurality of panels (1) in accordance with any one of claims 1 to 8, connected together in a grid.

11. Wall panelling comprising at least one panel (1) according to claims 1 to 8.

12. Wall panelling comprising a plurality of panels (1) according to claims 1 to 8, connected together in a grid.
